(19) Europäisches Patentamt / European Patent Office / Office européen des brevets

(11) **EP 2 104 140 A1**

(12) **EUROPEAN PATENT APPLICATION**

(43) Date of publication:
**23.09.2009 Bulletin 2009/39**

(21) Application number: **08425186.7**

(22) Date of filing: **21.03.2008**

(51) Int Cl.:
*H01L 23/367* (2006.01)　　*H01L 23/498* (2006.01)
*H01L 25/10* (2006.01)　　*H01L 21/68* (2006.01)

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Rise Technology S.r.l.**
**00040 Pomezia (IT)**

(72) Inventor: **Balucani, Marco**
**I-00040 Pomezia (RM) (IT)**

(74) Representative: **Pezzoli, Ennio**
**c/o Maccalli & Pezzoli S.r.l.**
**Via Settembrini 40**
**20124 Milano (IT)**

(54) **Conductive microstructure obtained by converting porous silicon into porous metal**

(57)　　A method for making a conductive microstructure (100) is proposed. The method starts with the step of providing a silicon substrate (102), which has a main surface. A porous silicon layer (103) - extending into the silicon substrate from the main surface - is then formed. The method continues by etching the porous silicon layer selectively to obtain a set of projecting elements of porous silicon (112); each projecting element projects from a remaining portion of the silicon substrate (106), thereby exposing a corresponding external surface. The projecting elements are then treated to obtain a set of corresponding conductive elements (115); each conductive element is obtained by converting at least a prevalent portion of the porous silicon (extending into the corresponding projecting element from the external surface) into porous metal.

FIG.1D

EP 2 104 140 A1

**EP 2 104 140 A1**

**Description**

The present invention in general relates to microstructures. More specifically, the present invention relates to conductive microstructures.

Conductive microstructures are commonly used in a myriad of applications. A typical example is a circuitized substrate for packaging a chip of semiconductor material (wherein an integrated circuit is formed). For instance, in an electronic device of the Ball Grid Array (BGA) type, the chip is mounted on an upper surface of the substrate. Terminals of the chip are then bonded to corresponding contacts (such as pads), which are provided on the same upper surface of the substrate (such as with a flip-chip technique). Through via-holes (or simply vias) cross the substrate, so as to connect the pads on its upper surface with corresponding conductive balls provided on a lower surface of the substrate. The structure so obtained is then enclosed within a protective cover (for example, of plastic material), which only leaves exposed the balls on the lower surface of the substrate (implementing external terminals of the electronic device).

In this context, a problem is due to the demand of higher and higher density of the contacts for the terminals of the chips; indeed, the growing complexity of the integrated circuits requires a huge number of terminals in the chips (especially for multiprocessor components), with a corresponding decrease of their pitch. However, even very sophisticated production processes - such as the ones based on the micro-via technology, also known as Sequential Build-Up (SBU) or High Density Interconnect (HDI) - do not allow obtaining vias with a diameter smaller than 50-80 μm.

Another problem of the know substrates is the requirement of very low resistance of the contacts (between the terminals of the chips and the terminals of the electronic device through the corresponding vias). For example, in complex System on Chips (SOCs), such as for mobile telephones wherein almost all the functions thereof are implemented in a few chips, the resistance of each contact should not exceed 70-80 mΩ.

The increasing terminal density of the chips also raises a big issue for the dissipation of heat that is produced by the chips; this may be very critical, especially at specific areas (hot-spots) where the heating of the chips concentrates.

A further problem concerns the reliability of the electronic devices. Indeed, any difference between the Thermal Coefficient of Expansion (TCE) of the chips and of the substrates may induce mechanical stresses on the chips (especially at their bonding with the substrates in the flip-chip technique). The problem is further exacerbated by the use of ultra-low-k dielectric materials, which impose that the substrates should virtually induce no stress on the chips.

Similar considerations apply to Package-On-Package (POP) structures, wherein two or more electronic devices (each one with the corresponding substrate) are mounted one above the other.

Equivalent, additional and/or different problems are also experienced in other technical fields that require the use of conductive microstructures. For example, this is the case of magneto-dielectric materials (such as for use in electromagnetic antennas), vacuum electronic devices (such as microware tubes), micro-mechanical structures (such as micro-gears), and so on.

Different aspects of the invention provide a solution as set out in the independent claims. Advantageous embodiments of the invention are set out in the dependent claims.

Particularly, an aspect of the invention proposes a method for making a conductive microstructure. The method starts with the step of providing a silicon substrate (having a main surface). A porous silicon layer - extending into the silicon substrate from the main surface - is then formed. The method continues by etching the porous silicon layer selectively to obtain a set of projecting elements of porous silicon; each projecting element projects from a remaining portion of the silicon substrate, thereby exposing a corresponding external surface. The projecting elements are then treated to obtain a set of corresponding conductive elements; each conductive element is obtained by converting at least a prevalent portion of the porous silicon (extending into the corresponding projecting element from the external surface) into porous metal.

Another aspect of the invention proposes a corresponding system (for example, a micro-mechanical structure, a magneto-dielectric structure, an interconnection structure, a packaged electronic device, a package-to-package electronic device, a power electronic device, or a vacuum electronic device).

The invention itself, as well as further features and the advantages thereof, will be best understood with reference to the following detailed description, given purely by way of a non-restrictive indication, to be read in conjunction with the accompanying drawings. In this respect, it is expressly intended that the figures are not necessary drawn to scale and that, unless otherwise indicated, they are merely intended to conceptually illustrate the structures and procedures described herein. Particularly:

FIGs.1A-1D show the various phases of a production process for making a conductive microstructure according to an embodiment of the invention,
FIGs.2A-2G show the various phases of a production process for making a conductive microstructure according to another embodiment of the invention,
FIGs.3A-3D show the additional phases of a production process for making an interconnection structure according to an embodiment of the invention,

FIGs.4-6 are exemplary packaged electronic devices that may be obtained with the solution according to an embodiment of the invention,

FIG.7 is an exemplary package-on-package electronic device that may be obtained with the solution according to an embodiment of the invention,

FIG.8 is an exemplary power electronic device that may be obtained with the solution according to an embodiment of the invention,

FIGs.9A-9D show the additional phases of a production process for making a vacuum electronic device according to an embodiment of the invention, and

FIG.10 illustrates exemplary micro-mechanical structures that may be obtained with the solution according to an embodiment of the invention.

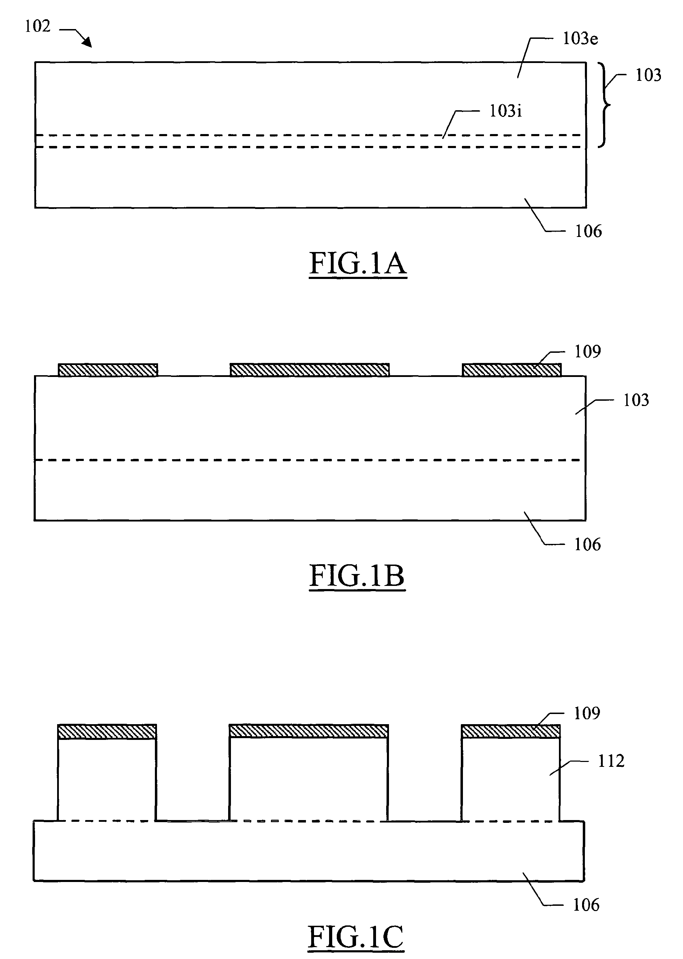

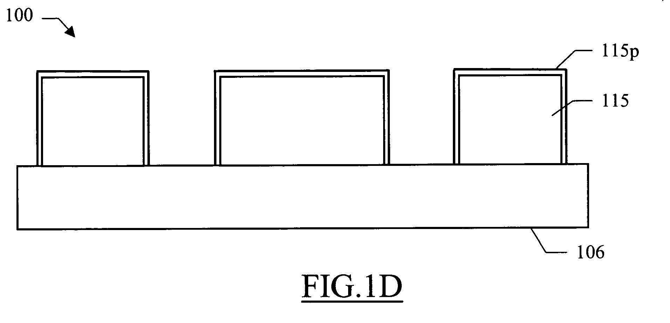

With reference in particular to FIGs.1A-1D, there are show the various phases of a production process for making a conductive microstructure (denoted in FIG.1D with the reference 100) according to an embodiment of the invention.

As shown in FIG.1A, the production process starts with a silicon substrate 102 (for example, consisting of a wafer of mono-crystalline silicon); a single structure may be formed on the full wafer, or the same structure may be repeated in a large number of identical areas of the wafer that are then diced at the end of the process. A porous silicon layer 103 is formed in the silicon substrate 102; the porous silicon layer 103 extends from a front (upper) surface of the silicon substrate 102, so as to leave a remaining portion thereof of non-porous silicon (denoted with the reference 106).

For this purpose, the silicon substrate 102 is subjected to an anodic process (acting on its front surface). Particularly, the silicon substrate 102 is used as an anode in an electrochemical cell (including an electrolyte being rich of Hydrofluoric acid, or HF). When a current density of the anodic process is lower than a critical value $J_{PS}$ (depending on multiple experimental factors), the electrolyte only reacts with holes that reach the front surface of the silicon substrate 102 (so that the reaction is limited by the feeding of the holes and not by their ionic diffusion into the electrolyte). Of course, this requires the availability of (free) holes at the front surface of the silicon substrate 102. The availability of holes is obvious if the silicon substrate 102 is of the P-type. Conversely, if the silicon substrate 102 is of the N-type the interface silicon-electrolyte acts as a reverse-biased Schottkly junction (i.e., with a depletion region whose width decreases as the concentration of impurities in the silicon substrate 102 increases). When the silicon substrate 102 has a high concentration of impurities (N+), the free holes in the silicon substrate 102 can pass through the potential barrier of this junction by quantum-mechanical tunneling; conversely, it is necessary to provide energy to the holes for allowing their passage through the potential barrier - for example, by lighting the silicon substrate 102 on its front surface and/or on a back (lower) surface thereof.

The porous silicon (PS) is classified as nanoPS (or microPS), mesoPS and macroPS according to a diameter of its pores; particularly, the diameter of the pores is lower than 2nm in the nanoPS, between 2nm and 50nm in the mesoPS, and higher than 50nm in the macroPS. In principle, the nanoPS is formed in every silicon substrate independently of its doping; however, a pure nanoPS can be obtained only in silicon substrates of the P-type with a low concentration of impurities. A mixture of nanoPS and mesoPS is instead obtained in silicon substrates with a high concentration of impurities (either of the N-type or of the P-type). At the end, the macroPS may be obtained in silicon substrates with low concentration of impurities (with nanoPS that is found to cover the pores when the silicon substrate is of the N-type).

The characteristics of the porous silicon depend on its morphology, which in turn is a function of different parameters of the anodic process (for example, the duration, the concentration and the type of impurities of the silicon, the current density, the type of electrolyte, and the like). In this context, the relevant characteristic of the porous silicon is its porosity ($Ps\%$), which is defined with respect to the (non-porous) silicon as:

$$P_{PS}\% = \left(1 - \frac{\rho_{PS}}{\rho_{Si}}\right)\%,$$

where $\rho_{PS}$ is the density of the porous silicon and $\rho_{Si}$ is the density of the silicon (i.e., 2.3 g/cm$^3$). The density of the porous silicon $\rho_{PS}$ can be measured by applying the following formula:

$$\rho_{PS} = \rho_{Si} - \frac{P_{Si} - P_{PS}}{S_{PS} \cdot D_{PS}},$$

where the values $P_{Si}$ (initial weight of the silicon substrate before the anodic process), $P_{PS}$ (ending weight of the silicon substrate after the anodic process) and $D_{PS}$ (thickness of the porous silicon layer) can be measured, while the value $S_{PS}$ (extension of the front surface of the silicon substrate being subjected to the anodic process) is known.

The porosity $P_{PS}\%$ depends on the parameters of the anodic process; particularly, the porosity $P_{PS}\%$ increases as the electrolyte concentration decreases and/or as the current density increases. Therefore, in order to obtain a uniform porosity $P_{PS}\%$ in the porous silicon layer 103 those parameters should be maintained constant over time. However, when the thickness $D_{PS}$ of the porous silicon layer 103 is relatively high (for example, more than 50 $\mu$m), the electrolyte concentration in a lower portion of the porous silicon layer 103 decreases (with respect to its value in an upper portion thereof) because of a limitation in its ionic diffusion. Nevertheless, it is still possible to obtain the desired uniform porosity $P_{PS}\%$ by decreasing the current density over time accordingly (e.g., with a linear law). For example, the following experimental results were obtained with a silicon substrate of the N+ type having a resistivity of 0.01-0.02 $\Omega$cm, which silicon substrate was immersed into an electrolyte HF:$C_2H_5$OH=3:1; the anodic process was performed at room temperature, by applying the following regimes of the current density:

| Sample No. | Current Density | | | | Thickness [$\mu$m] | Porosity |
|---|---|---|---|---|---|---|
| | Start Value [mA/cm$^2$] | End Value [mA/cm$^2$] | Decreasing Law | Time [s] | | |
| 1 | 70 | 60 | Linear | 2400 | 145 | 36,80% |
| 2 | 40 40 | - 20 | Constant Linear | 600 2000 | 100 | 25,20% |
| 3 | 100 | 40 | Linear | 3600 | 203 | 50,80% |
| 4 | 120 | 60 | Linear | 2880 | 200 | 64,80% |
| 5 | 120 | 30 | Linear | 5000 | 310 | 62,30% |
| 6 | 40 | - | Constant | 600 | 34,8 | 25,50% |
| 7 | 80 | - | Constant | 600 | 49,8 | 46,80% |

The regimes of the electrolyte concentration and/or of the current density can be changed without any problem in order to obtain the desired thickness $D_{PS}$ and porosity $P_{PS}\%$ of the porous silicon layer 102. For example, the thickness $D_{PS}$ can range from 1 $\mu$m to 500 $\mu$m; the porosity $P_{PS}\%$ can instead range from 10% (in case on macroPS) or from 20% (in case of nanoPS or mesoPS) to 85-95%.

In some applications - when the (remaining) silicon substrate 106 is to be removed, as described in the following - it is preferable to a have a (thicker) external portion of the porous silicon layer (denoted with 103e) with a uniform porosity $P_{PS}\%$, and a (thinner) internal portion thereof (denoted with 103i) with a higher porosity $P_{PS}\%$ (for example, equal to 1.2-2.0 times the one of the external portion 103e). The internal portion 103i may be obtained by increasing the current density at the end of the anodization process. For example, by applying a pulse with a constant current density of 120mA/cm$^2$ for 30s after the anodic process providing the sample No.4 in the table above (thickness 200 $\mu$m and porosity $P_{PS}\%$=64,80% of the external portion 103e), it is possible to obtain an internal portion 103i with a thickness of 1.5-1.8 $\mu$m and a porosity $P_{PS}\%$=85%.

Continuing to FIG.1B, an etching mask 109 is formed on the front surface of the porous silicon layer 103. The mask 109 consists of a thin layer of material (for example, with a thickness of 10-50 nm), which is adapted to protect the porous silicon layer 103 during a next etching process; for example, the mask 109 may be made of a metal like Ni, Au, Pt, Ti, Al and Cr - for a Reactive Ion Etching (RIE) process - and of a dielectric like SiO$_2$ or a photo-resist - for a Deep-RIE (DRIE) process based on the Bosch method. The mask 109 is patterned so as to leave exposed areas of the porous silicon layer 103 where conductive elements of the final microstructure are desired. This result may be achieved with a photolithographic process. For this purpose, a masking layer is deposited on the porous silicon layer 103. A photo-resist layer is in turn deposited on the masking layer and shaped photo-lithographically so as to leave exposed the portions of the masking layer to be removed through an etching process. Alternatively, the same result may also be achieved with a lift-off process. In this case, a photo-resist layer is deposited on the porous silicon layer 103 and shaped photo-lithographically so as to be removed from the areas of the conductive elements. A masking layer is then deposited on the photo-resist layer and on the exposed areas of the porous silicon layer 103. The photo-resist layer is now removed, taking away the masking layer being formed on it; therefore, the masking layer remains on the areas of the conductive elements only. In this case, however, when a positive photo-resist material is used (requiring an alkaline solution for its development), it is necessary to protect the porous silicon layer 103 beforehand (so as to avoid any undesired etching thereof due to its porosity). For this purpose, it is possible to protect the porous silicon layer 103 with a thin layer (not shown in the figure) of $SiO_2$ or poly-silicon - such as with a thickness lower than 0.5 $\mu$m (e.g., 100 nm) - which is deposited on the porous silicon layer 103 by means of a thin film process.

The process continues to FIG.1C, wherein the porous silicon layer 103 is subjected to an etching process through the mask 109; the etching process is of the anisotropic type - i.e., with a very low ratio between its lateral etching rate and vertical etching rate - in order to obtain the conductive elements with the desired shape as defined by the mask 109. For this purpose, it is possible to use a plasma etching process of the RIE type with a suitable gas (e.g., high concentration of $CHF_3$ with respect to $SF_6$), high Radio-Frequency (RF) power, and/or low pressure. At instance, a RIE process with an RF power of 250 W and a pressure of 20 mTorr provides a lateral/vertical ratio equal to 1:10 or 1:65 with a gas $SF_6$ or $CHF_3$:$SF_6$=17:3, respectively. Far lower lateral/vertical ratios (down to 1:500) can instead be obtained with a plasma etching process of the DRIE type based on the Bosch method. At the same time, the vertical etching rate (increasing with the porosity $P_{PS}\%$ for values thereof up to 55%) should be kept relatively low, so as to allow controlling the extent of the etching (down to the silicon substrate 106) with the desired level of accuracy. Typically, suitable values of the vertical etching rate are 1-7 $\mu$m/min. When very strict accuracy requirements apply, it is instead necessary to use far lower vertical etching rates (down to 100 nm/min); for example, this result may be achieved in a DRIE process by simply decreasing the RF power (since the lateral/vertical ratio remains in any case low), or in a RIE process by changing the gas (such as increasing the $CHF_3$ concentration or using $NF_3$,$CF_4$ with a mixture of $O_2$) to maintain an acceptable lateral/vertical ratio.

The etching process generates projecting elements 112 (of porous silicon) corresponding to the desired conductive elements; particularly, each projecting element 112 projects upwardly from the silicon substrate 106, so as to expose a corresponding external surface (laterally and at the top, below the mask 109).

Moving to FIG.1D, the mask (109 in FIG.1C) is removed (for example, with a wet etching process). The projecting elements (112 in FIG.1C) are then treated so as to obtain corresponding conductive elements 115; particularly, the porous silicon extending into the projecting elements (from their external surfaces) is converted into porous metal. For this purpose, the structure is immersed into a suitable solution; the type of solution determines the porous metal that is obtained and its morphology (which may be either the same as or different from the morphology of the porous silicon), while the length of the process determines the extent of the conversion (which may involve the whole projecting elements or only a portion thereof). For example, a solution of 0.025M $CuSO_4 \cdot 5H_2O$+0.01M HF was used to convert projecting elements (with a height of 200 $\mu$m, a width of 50 $\mu$m and a porosity $P_{PS}\%$=50%) completely into corresponding conductive elements 115 of porous copper (with a porosity $P_{PM}\%$=64.80%) in 30 min; the same process was used to convert only a portion of the projecting elements with a thickness of 25 $\mu$m or 10 $\mu$m in 25 min or 7 min, respectively. Naturally, by changing the solution it is possible to obtain any other porous metal, such as Ni, Au, Pt, Ru, Ag, and so on. Similar processes (also known as displacement or corrosive depositions) have already been reported by researchers in completely different applications - that is, only for converting porous silicon layers of the uniform type into porous metal films of the continuous type to be used as catalysts in full-cells or batteries - for example, as described in Xi Zhang, King-Ning Tu, "Preparation of hierarchically porous nickel from macroporous silicon" J. Am. Chem. Soc. 2006, 128, 15036-15037, in M. Hayase et al. "Formation of porous ruthenium layer on porous silicon template" Electrochem. Soc. 2006, 153, C741, in H. Bandarenka, M. Balucani, R. Crescenzi, A. Ferrari, "Formation of composite nanostructures by corrosive deposition of copper into porous silicon" Superlattices and Microstructures, In Press, Corrected Proof, Available online 24 January 2008, in M. Hayase et al. "Miniature 250$\mu$m thick full cell with monolithically fabricated silicon electrodes", Electrochemical and Solid State Letters, 7 (8) A231-A234 (2004), in F.A.Harraz et al. "Immersion plating of nickel onto a porous silicon layer from fluoride solutions" Phys. Stat. Sol. (a), 2003, 197, 51-56, or in J. G. A. Brito-Neto et al. "Porous gold structures built on silicon substrates" 211th ECS Meeting Abstracts, N° 877(2007), the entire disclosures of which are herein incorporated by reference.

As a result, there is obtained the desired conductive microstructure 100 that may be used in a myriad of applications (as described in detail in the following).

The proposed solution is very flexible, since it allows obtaining conductive elements 115 with a wide range of (electrical and/or mechanical) characteristics. Particularly, the conductive elements 115 may have any kind of shape; for example, the conductive elements 115 may be in the form of pillars - with a circular, squared, or any other section - in the form of walls - such as straight, broken, or curved, such as open or closed, and such as with a uniform or a variable width (either enlarging at the middle or at the ends) - or in the form of complex 3-dimensional (3D) structures. The shape of the conductive elements 115 is only constrained by the technological limits of the above-described etching process that is exploited for their definition and by the desired mechanical stability (also depending on the porosity $P_{PM}\%$ of the porous metal). Generally, conductive structures 115 with an aspect ratio (between their height and width) up to 20-30 can be made with any shape and porosity $P_{PM}\%$ without problems; for example, it is possible to make conductive elements 115 in the form of pillars with a height of 200-300 $\mu$m and a width of 8-12 $\mu$m (of course, higher and/or thinner conductive elements 115 are possible with other shapes). The porosity $P_{PM}\%$ and/or the extent of the conversion from porous silicon to porous metal also allow controlling the weight and the rigidity of the conductive elements 115 (with the higher the porosity $P_{PM}\%$ and the lower the extent of the conversion, the lower the weight and the rigidity). The same parameters may also be used to control the resistance of the conductive elements 115 (which decreases with the porosity $P_{PM}\%$ and the extent of the conversion). In this respect, a unique mathematical formula that expresses the electrical resistivity of the porous metal as a function of its porosity $P_{PM}\%$ is still under investigation by the scientific community (since it depends on the type of porous metal that is obtained - i.e. foam metal, sintered powder metal, etc.). Any way, it was found that experimental data on porous copper substantially matches the following formula (proposed for the first time in the NASA topical report "Thermal conductivity and electrical resistivity of porous material" CR-l20854 - October 1971):

$$\rho_{PM} = \rho_M \frac{1 + K \cdot (P_{PM}\%)^2}{1 - P_{PM}\%},$$

wherein $\rho_{PM}$ and $\rho_M$ are the electrical resistivity of the porous copper and of the (uniform) non-porous copper, respectively, and K a fitting parameter obtained experimentally that is set equal to 11 (as in the NASA report for porous copper obtained by sintered powder).

Optionally, the conductive elements 115 may also be covered with a thin (non-porous) metal layer 115p (either of the same type as or of a different type of the porous metal of the conductive elements 115). For example, this result may be achieved with an (electrolytic or electro-less) plating process. In this way, it is possible to reduce the resistance of the whole structure and/or to increase its mechanical stability (without substantially affecting the shape thereof).

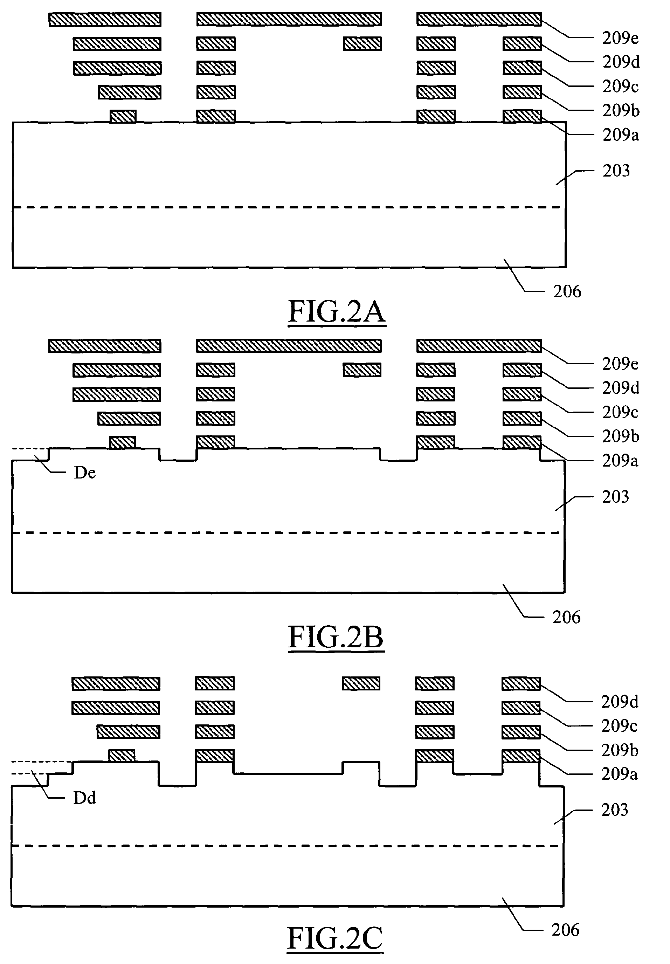

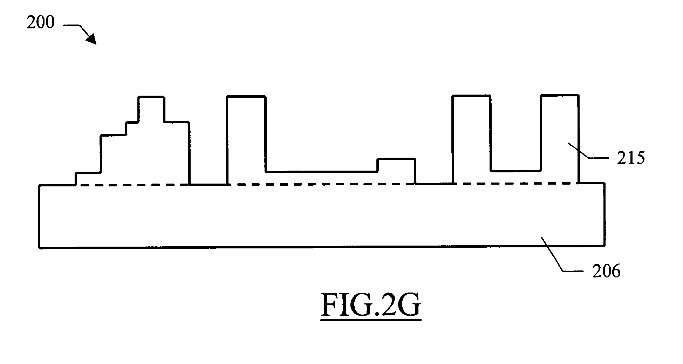

Moving now to FIGs.2A-2G, there are show the various phases of a production process for making a conductive microstructure (denoted in FIG.2G with the reference 200) according to another embodiment of the invention (in the following, the elements corresponding to the ones shown in the preceding figures are denoted with similar references obtained by simply changing their first number, and the corresponding explanation is omitted for the sake of exposition brevity).

As shown in FIG.2A, a porous silicon layer 203 is formed on a silicon substrate 206 as described above. A plurality of N etching masks (with N≥2) is then formed on the front surface of the porous silicon layer 203, in order to obtain corresponding 3-D conductive elements with N-1 layers along their extension from the silicon substrate 206 (with each layer that has a different width transversally to the extension of the conductive elements); particularly, in the example at issue five masks 209a, 209b, 209c, 209d and 209e are illustrated. The masks 209a-209e are stacked one on the other, starting from the lowest mask 209a that is arranged directly on the porous silicon layer 203 (although the masks 209a-209e are separated in the figure for the sake of clarity, it should be understood that in reality they are directly in contact); it should be noted that the non-planarity of the masks 209a-209e is substantially negligible (since the masks 209a-209e are very thin - i.e., 10-100 nm), so that it does not create any problem during the corresponding photolithographic processes. The masks 209a-209e are made of different materials, which may be etched selectively one to the others (so as to allow their removal individually); for example, the masks 209a, 209b, 209c, 209d and 209e may be made of Pt, Au, Ti, Ni and Al, respectively. Each mask 209a-209e is patterned according to the desired shape of the corresponding layer of the conductive elements (with the resulting conductive elements that are defined on the whole by the complex of the masks overturned vertically).

The process continues to FIG.2B, wherein the porous silicon layer 203 is etched as above through the masks 209a-209e (i.e., through the uppermost mask 209e covering all the lower masks 209a-209d). The etching is performed for a corresponding partial thickness De (lower than the initial thickness $D_{PS}$ of the porous silicon layer 203).

Moving to FIG.2C, the uppermost mask (209e in FIG.2B) is removed; for example, this result may be achieved with a wet etching process in a solution of 10% $K_3Fe(CN_6)$, which does not affect the lower masks 209a-209d. The porous silicon layer 203 is likewise etched through the masks 209a-209d (i.e., through the uppermost mask 209d) for a corresponding partial thickness Dd.

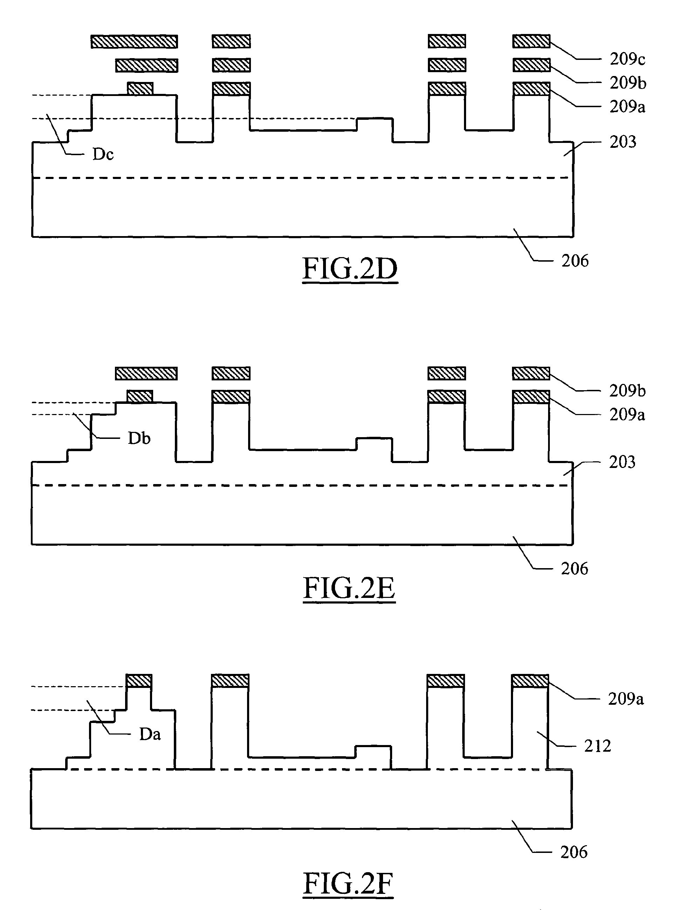

With reference now to FIG.2D, the uppermost mask (209d in FIG.2C) is removed; for example, this result may be achieved with a wet etching process in a solution of $FeCl_3$, which does not affect the lower masks 209a-209c. The porous silicon layer 203 is likewise etched through the masks 209a-209c (i.e., through the uppermost mask 209c) for a corresponding partial thickness Dc.

The process continues to FIG.2E, wherein the uppermost mask (209c in FIG.2D) is removed; for example, this result may be achieved with a wet etching process in a solution of $H_2SO_4$, which does not affect the lower masks 209a-209b. The porous silicon layer 203 is likewise etched through the masks 209a-209b (i.e., through the uppermost mask 209b) for a corresponding partial thickness Db.

At the end, as shown in FIG.2F, the uppermost mask (209b in FIG.2D) is removed; for example, this result may be achieved with a wet etching process in a solution of $I_2$:KI:$H_2$O=1:2:10, which does not affect the lower mask 209a. The porous silicon layer 203 is likewise etched through the remaining mask 209a for a corresponding partial thickness *Da*. As a result, there are obtained projecting elements 212 (of porous silicon) corresponding to the desired conductive elements.

Moving to FIG.2G, the last mask (209a in FIG.2F) is removed - for example, with a wet etching process in a solution of $HCl:HNO_3=3:1$. The projecting elements (212 in FIG.2F) are then treated as above so as to obtain corresponding conductive elements 215 of porous metal. This provides the desired conductive microstructure 200.

This embodiment of the invention allows obtaining 3-D conductive elements 215 with any kind of shapes.

Some examples of application of the above-described conductive microstructure are now described in detail.

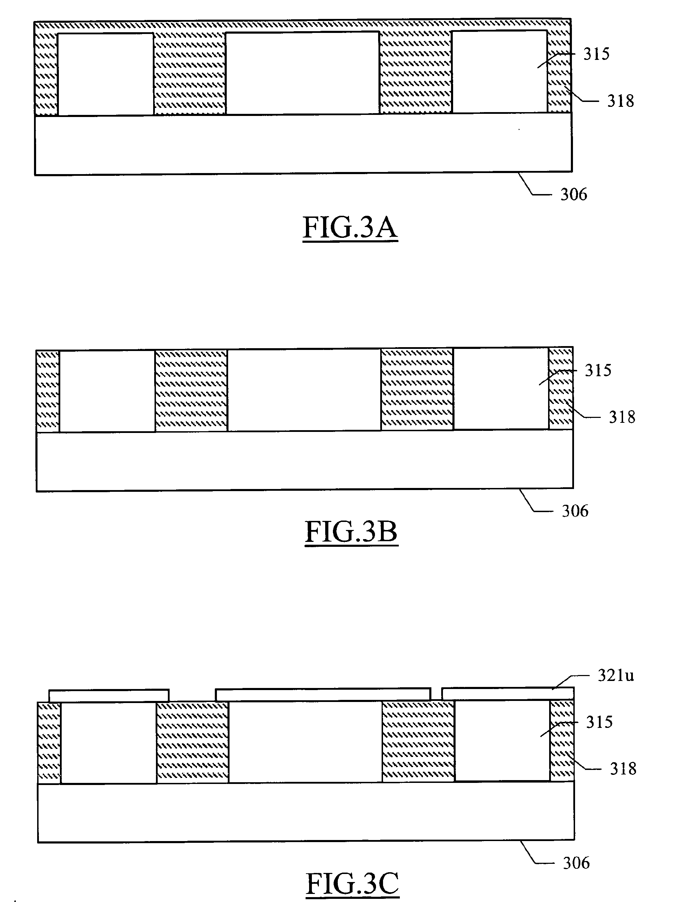

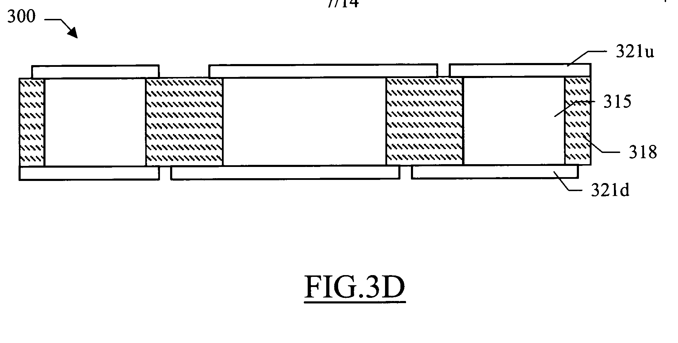

For example, FIGs.3A-3D show the additional phases of a production process for making an interconnection structure (denoted in FIG.3D with the reference 300) according to an embodiment of the invention.

Starting from FIG.3A, conductive elements 315 are formed on a silicon substrate 306 as described above. A dielectric material is then applied on the silicon substrate 306 so as to embed the conductive elements 315; the dielectric material may be any thermoplastic resin (such as nylon or liquid crystal polymer), thermosetting resin, ceramic precursor, and the like. The dielectric material can be applied by any suitable technique like casting, injection molding, dispensing, stencil printing, lamination, and the like. The dielectric material is then treated so as to obtain a corresponding dielectric layer 318 (embedding the conductive elements 315). For example, the dielectric material may be subjected to a curing, sintering and/or pyrolisis process; in this respect, it should be noted that the open structure of the conductive elements 315 (which project from the silicon substrate 309 freely) strongly facilitates this operation. According to the dielectric material that was applied on the silicon substrate 306, the dielectric layer 318 may be either elastic or rigid.

The process continues to FIG.3B, wherein the dielectric layer 318 is planarized at the level of the conductive elements 315 (for example, with a grinding, polishing or lapping process).

With reference now to FIG.3C, contact elements 321u are formed on an upper surface of the dielectric layer 318. At instance, the contact elements 321u consist of bonding pads and routing tracks (made of metal), which are connected to the conductive elements 315; for example, this result may be achieved with a thin and/or thick film process.

Moving to FIG.3D, the silicon substrate (306 in FIG.3C) is removed (for example, with a grinding and/or $XeF_2$ vapor etching process). Further contact elements 321d are likewise formed on a lower surface of the dielectric layer 318 (as above, with a thin and/or thick film process providing bonding pads and routing tracks connected to the conductive elements 315). As a result, there is obtained the desired (rigid or flexible) interconnection structure 300.

The proposed solution allows achieving a very high contact density (for example, of the order of 200k-400k contacts/cm$^2$); at the same time, the porous structure of the conductive elements 315 provides a very high adhesion with the dielectric layer 318, thanks to the penetration of the dielectric material into the porous metal.

The same process described above (without the steps of forming the upper and lower contact elements) may also be used to make a magneto-dielectric structure. For this purpose, the conductive elements are of a porous magnetic metal (for example, Ni or Fe), which has a relative magnetic permeability $\mu_r$ far higher than 1. At the same time, the dielectric layer has a relative dielectric permittivity $\varepsilon_r$ far higher than 1; for example, this result may be achieved by filling the corresponding dielectric material with nano-particles of strontium titatate (with $\varepsilon_r=310$). The structure so obtained (after removing the silicon substrate) behaves as a magneto-dielectric material - which is seen as a uniform material (with high relative magnetic permeability $\mu_r$ and high relative dielectric permittivity $\varepsilon_r$) by any electromagnetic (EM) wave propagating across it. For example, this magneto-dielectric material may be used to make EM antennas with reduced size.

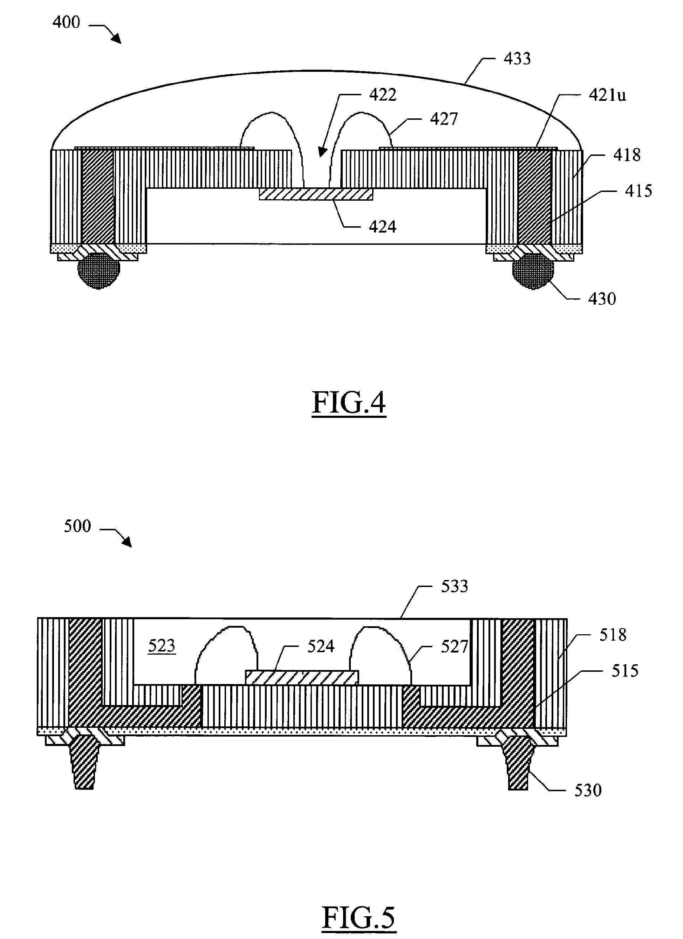

With reference now to FIG.4, there is shown an exemplary packaged electronic device 400 that may be obtained with the solution according to an embodiment of the invention. The electronic device 400 includes a circuitized substrate made of a (rigid) interconnection structure - with conductive elements 415 embedded in a dielectric layer 418 having upper contact elements 421u - that is obtained as described above. A through hole 422 with a lower spot-facing is formed through the dielectric layer 418 (for example, by a hot pressing process when it derives from a thermoplastic material). A chip of semiconductor material 424 (integrating a corresponding circuit) is mounted within the spot-facing of the hole 422, so as to expose corresponding terminals (not shown in the figure) through the hole 422. The terminals of the chip 424 are bonded through wires 427 to corresponding pads of the contact elements 421u; the routing tracks of the contact elements 421u then connect these pads to corresponding conductive elements 415. External terminals 430 of the electronic device 400 - in the form of conductive balls with Under Bump Metallizations (UBMs) - are connected to the conductive elements 415 on a lower surface of the dielectric layer 418. A protective cover 433 (for example, of plastic material) embeds the chip 424 and the wires 427, so as to leave exposed the terminals 430 only.

The proposed solution allows obtained a circuitized substrate (with the desired high density, low resistance, and high heat dissipation), which exhibits a TCE very similar to the one of silicon; in this way, it is possible to avoid (or at least substantially reduce) any mechanical stress on the chip 424. For example, conductive elements of porous copper with a porosity $P_{PM}\%=55\%$ have a TCE=8.0 ppm/°C, that is far more similar to the TCE=2-5 ppm/°C of the silicon than the TCE=17 ppm/°C of non-porous copper is (at the same time providing a very low resistivity of 15.7 $\mu\Omega$cm).

Moving to FIG.5, there is shown another exemplary packaged electronic devices 500 that may be obtained with the solution according to an embodiment of the invention. The electronic device 500 includes a circuitized substrate made of a (rigid) interconnection structure - with 3-D conductive elements 515 embedded in a dielectric layer 518 - that is obtained as described above. An embossment 523 is formed on an upper surface of the dielectric layer 518 (for example, again by a hot pressing process when it derives from a thermoplastic material). A chip of semiconductor material 524 is mounted within the embossment 523, and its terminals (not shown in the figure) are bonded through wires 527 to corresponding conductive elements 515 (being exposed in the embossment 523); the conductive elements 515 in turn connect the wires 527 to corresponding external terminals 530 of the electronic device 500 - in the form of conductive pillars with UBMs - on a lower surface of the dielectric layer 518. A protective cover 533 embeds the chip 524 and the wires 527, so as to leave exposed the terminals 530 only.

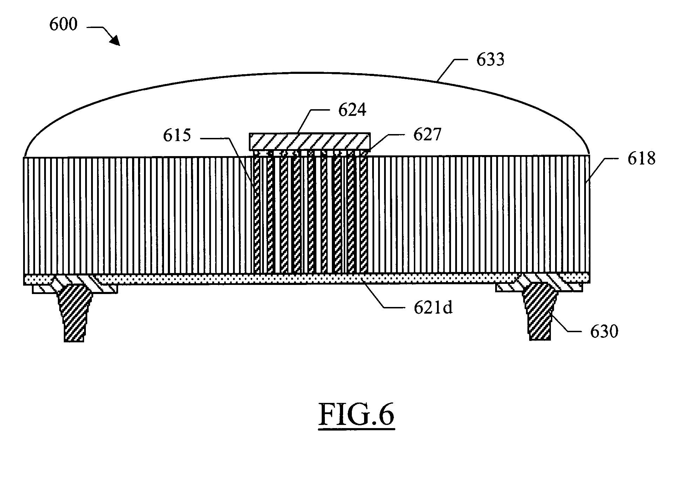

Considering now FIG.6, there is shown a further exemplary packaged electronic devices 600 that may be obtained with the solution according to an embodiment of the invention. The electronic device 600 includes a circuitized substrate made of a (rigid) interconnection structure - with conductive elements 615 embedded in a dielectric layer 618 having lower contact elements 621d - that is obtained as described above. A chip of semiconductor material 624 in mounted with a flip-chip technique above the dielectric layer 618; in this case, bonding balls 627 are used to connect terminals (not shown in the figure) of the chip 624 - turned upside-down- to corresponding conductive elements 615; the conductive elements 615 connect the balls 627 to corresponding routing tracks of the contact elements 621d. External terminals 630 of the electronic device 600 - in the form of conductive pillars with UBMs - are connected to the routing tracks of the contact elements 621d. A protective cover 633, if necessary, embeds the chip 624 and the balls 627, so as to leave exposed the terminals 630 only.

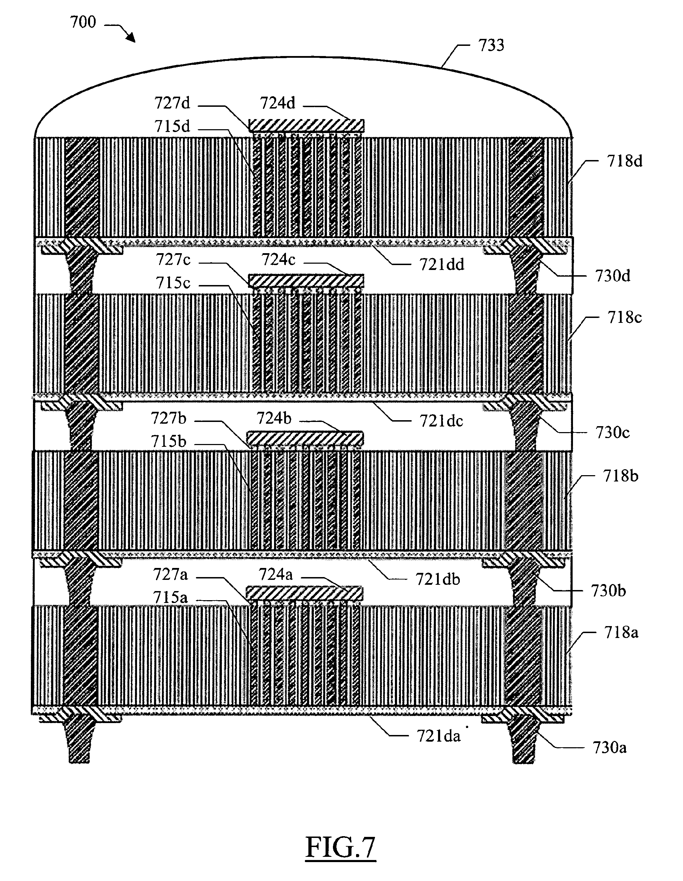

As shown in FIG.7, an exemplary package-on-package electronic device that may be obtained with the solution according to an embodiment of the invention is denoted with the reference 700. The electronic device 700 includes a plurality of circuitized substrates (four in the example at issue), each one made of a (rigid) interconnection structure - with conductive elements 715a-715d embedded in a dielectric layer 718a-718d having lower contact elements 721da-721dd and terminals 730a-730d (in the form of conductive pillars which UBMs) - that is obtained as described above. In this case as well, a chip of semiconductor material 724a-724d is mounted with a flip-chip technique above the dielectric layer 718a-718d, by means of bonding balls 727a-727d that are connected to corresponding (central) conductive elements 715a-715d, routing tracks of the contact elements 721da-721dd, and terminals 730a-730d. The circuitized substrates are stacked one on the other; each circuitized substrate includes further (lateral) conductive elements 715a-715d, which are connected to the terminals 730b-730d of the circuitezed substrate that is immediately above it. A lowest circuitized substrate in the stack includes further terminals 730a, which are connected to the further conductive elements 715a thereof (and then to the chips 724b-724d). A protective cover embeds all the chips 724a-724d and the corresponding balls 727a-727d (either individually or together), so as to leave exposed all the external terminals 730a of the lowest circuitized substrate (for accessing both its chip 724a and the other chips 724b-724d).

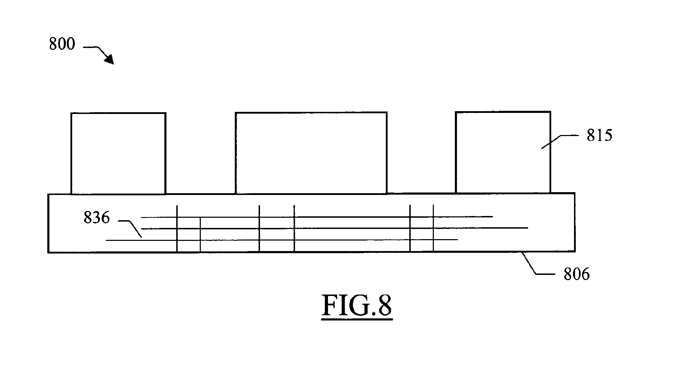

Descending to FIG.8, there is shown an exemplary power electronic device 800 that may be obtained with the solution according to an embodiment of the invention. The electronic device 800 is made by forming conductive elements 815 on a silicon substrate 806 as described above. One or more power components 836 (such as IGBTs) are integrated in the silicon substrate 806 (from its lower surface). In this case, the conductive elements 815 implement a heat sink for dissipating the heat that is generated by the power components 836 in operation.

The proposed solution allows making the heat sink 815 directly integral with the silicon substrate 806 (without requiring any additional bonding operation); this strongly simplifies the corresponding production process and improves the heat dissipation.

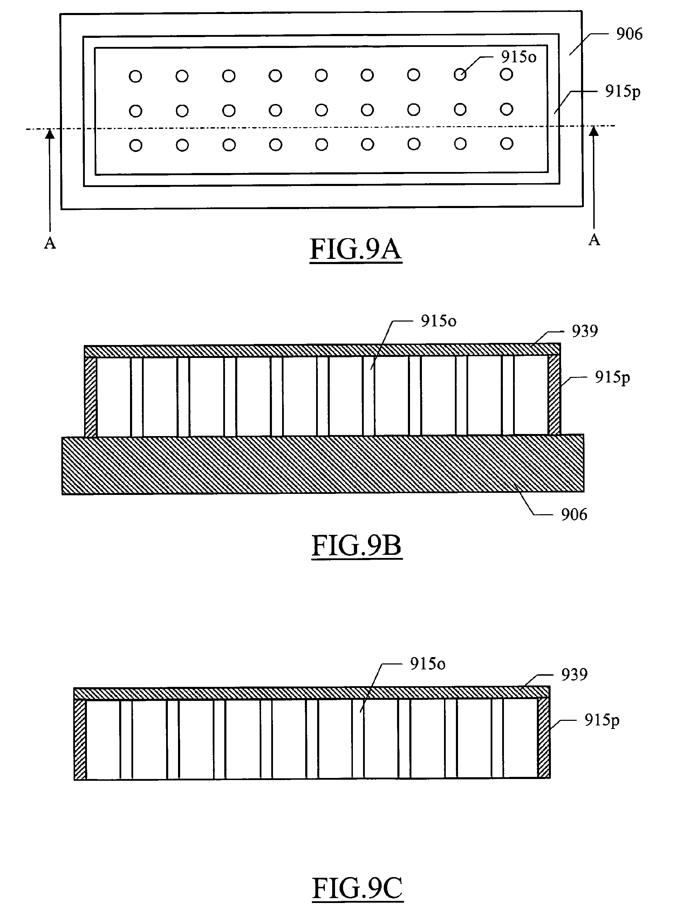

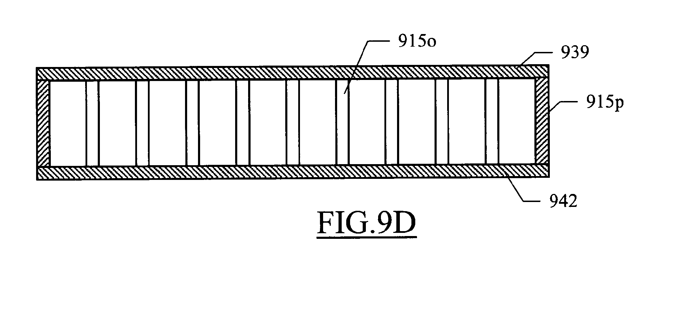

FIG.9A-9D instead show the additional phases of a production process for making a vacuum electronic device - denoted in FIG.9D with the reference 900 - according to an embodiment of the invention.

Starting from the plant view of FIG.9A, conductive elements are formed on a silicon substrate 906 as described above. Particularly, in this case a plurality of (operative) conductive elements 915o (for example, in the form of pillars) are surrounded by a (protection) conductive element 915p (for example, in the form of a squared frame).

The process continues to FIG.9B (showing a cross-section along the plan A-A of FIG.9A), wherein a protection plate 939 - for example, made of metal or with a metal/dielectric structure - is bonded on an upper free end of the conductive elements 915o,915p (for example, with a soldering process).

Moving to FIG.9C, the silicon substrate (906 in FIG.9B) is removed as described above.

With reference now to FIG.9D, a further protection plate 942 - either equal to or different from the plate 939 - is likewise bonded on a lower free end of the conductive elements 915o,915p under substantially vacuum conditions (for example, with a pressure lower than $10^{-3}$ hPa that gives a mean free path for particles of more than 10 cm). As a result, the (protection) elements 915p, plate 939 and plate 942 hermetically seal the conductive elements 915o, so as to provide the desired electronic device 900. In this way, depending on the geometry of the conductive elements 915o and/or 915p, it is possible to obtain a Field Emission Device, or FED (such as a triode, a penthode, etc.), a microwave microguide, a microwave linear-beam tube (e.g., a klystron or a travelling wave tube), or a microwave crossed-field tube (e.g., a magnetron oscillator, a forward wave crossed-field amplifier, etc.), especially for working frequencies in the TeraHz region.

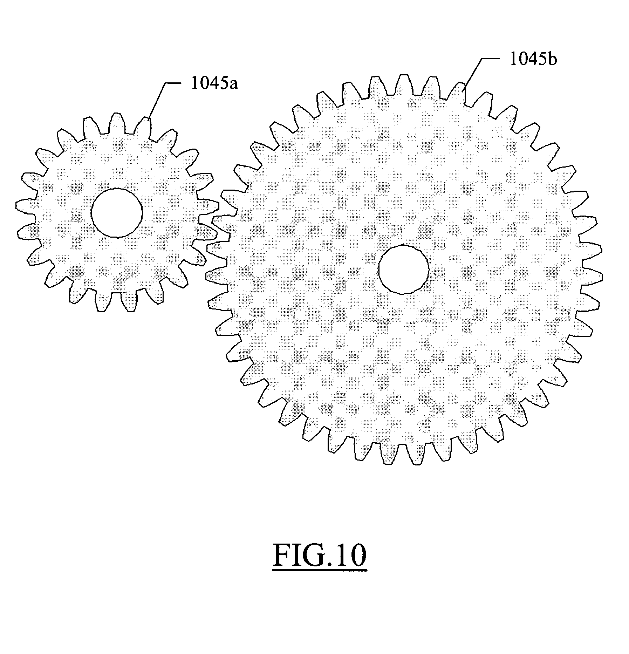

At the end, FIG.10 illustrates exemplary micro-mechanical structures that may be obtained with the solution according to an embodiment of the invention. In this case, conductive elements with the desired shape are formed on a silicon substrate, which is then removed as described above. Particularly, the figure shows a pair of micro-cogwheels 1045a and 1045b.

The proposed solution allows making whatever micro-mechanical structure with a very high accuracy; moreover, it is possible to control several mechanical characteristics thereof (such as weight and rigidity) at will.

Naturally, in order to satisfy local and specific requirements, a person skilled in the art may apply to the solution described above many logical and/or physical modifications and alterations. More specifically, although the present invention has been described with a certain degree of particularity with reference to preferred embodiment(s) thereof, it should be understood that various omissions, substitutions and changes in the form and details as well as other embodiments are possible. Particularly, the proposed solution may even be practiced without the specific details (such as the numerical examples) set forth in the preceding description to provide a more thorough understanding thereof; conversely, well-known features may have been omitted or simplified in order not to obscure the description with unnecessary particulars. Moreover, it is expressly intended that specific elements and/or method steps described in connection with any disclosed embodiment of the invention may be incorporated in any other embodiment as a matter of general design choice.

Particularly, the proposed solution lends itself to be implemented with an equivalent method (by using similar steps, removing some steps being non-essential, or adding further optional steps); moreover, the steps may be performed in a different order, concurrently or in an interleaved way (at least in part).

Similar considerations apply if the starting material is any other silicon substrate (even made of polysilicon). Moreover, the porous silicon layer may have a different thickness and/or porosity. The above-described etching processes are merely illustrative - with equivalent results that may be achieved by using plasma etching processes with different parameters (such as gas, RF power and/or pressure), or more generally with whatever dry etching process (such as sputtering, ion milling, or laser ablation). Likewise, the porous metal may be obtained with equivalent conversion processes (for example, using different solutions). As above, the conductive elements may have any other shape and/or porosity; in any case, it is also possible to have bi-phase conductive elements with an external portion of porous metal and an internal core of porous silicon.

Noting prevents changing the current density over time with a different law (e.g., parabolic, hyperbolic or step decrease, multiple constant pulses followed by any decrease, and the like). More generally, the desired structure of the porous silicon layer may be obtained with any other anodization regime of the anodic process, even by acting on additional and/or different parameter(s) thereof (such as the electrolyte concentration). In any case, the porous silicon may be completely uniform, or it may have a variable porosity (for example, decreasing and/or increasing towards the silicon substrate).

Moreover, any other process may be used to cover the conductive elements (or parts thereof) with whatever material - even if this step is merely optional.

The proposed solution lends itself to be implemented with any number of masks to obtain any kind of 3-D conductive elements; likewise, the masks may have different shape and/or they may be of different material.

Alternatively, it is possible to form the dielectric layer with any other technique, material and/or extension (with the conductive elements that may also be left partially or even completely free); moreover, the silicon substrate may be removed with any other technique.

Nothing prevents making the magneto-dielectric material with any other porous metal and/or dielectric material; naturally, the mentioned applications of the magneto-dielectric material are merely illustrative, and they must not be interpreted in a limitative manner.

In the proposed interconnection structure, the contact elements may be provided on both its opposed surfaces, only on one of them, or they may even be missing (for example, for use of the interconnection structure as a resilient interposer).

Anyway, the interconnection structure may be formed with any other contact elements (even with a multi-layer structure).

The above-described packaged electronic devices are not exhaustive, with the proposed circuitized substrate that may be used for mounting one or more chips that are connected in whatever manner to any kind of external terminals of the electronic device - either of the Single Chip Module (SCM) or Multi Chip Module (MCM) type.

Likewise, the package-to-package electronic device may include any number and/or type of components (even different to each other), which are connected in any other way through the proposed substrates (for example, via conductive balls).

Similar considerations apply if any other components (such as power MOSs or CMOSs) are integrated in the silicon substrate with the proposed heat sink.

Moreover, there is not excluded the possibility of forming the vacuum electronic devices with different protection plates, or any equivalent element (for example, made of metal/dielectric), or of surrounding the (operative) conductive elements with any other protection element (for example, made of porous silicon); moreover, the vacuum electronic devices may be of any other shape and/or type (even obtained under different vacuum conditions).

In any case, it is emphasized that the above-described examples of application of the proposed solution are not exhaustive; more generally, the same technique may be used to make any electronic and/or mechanical microstructure - such as micro-gears, micro-springs, micro-shafts, passive components (like inductors, capacitors, transformers and baluns), reading and/or writing heads for magnetic hard-disks, Micro Electro Mechanical Systems (MEMSs), and so on.

Similar considerations apply if the systems that are obtained with the proposed method have a different structure or include equivalent components.

It should also be readily apparent that the design of the microstructures may be created in a programming language; moreover, if the designer does not fabricate the microstructures, the design may be transmitted by physical means to others. In any case, the resulting microstructures may be distributed by its manufacturer in raw wafer form, as bare dies, or in packages. Moreover, the proposed microstructures may be integrated with other components, or they may be mounted in intermediate products (such as mother boards). In any case, the microstructures are suitable to be used in complex systems (such as computers).

**Claims**

1. A method for making a conductive microstructure (100), the method including the steps of:

   providing a silicon substrate (102), the silicon substrate having a main surface,
   forming a porous silicon layer (103) extending into the silicon substrate from the main surface,
   etching the porous silicon layer selectively to obtain a set of projecting elements of porous silicon (112), each projecting element projecting from a remaining portion of the silicon substrate (106) thereby exposing a corresponding external surface, and
   treating the projecting elements to obtain a set of corresponding conductive elements (115), each conductive element being obtained by converting at least a prevalent portion of the porous silicon, extending into the corresponding projecting element from the external surface, into porous metal.

2. The method according to claim 1, wherein the step of forming a porous silicon layer (103) includes:

   subjecting the silicon substrate (102) to a first anodic process with a first anodization regime to obtain an external portion of the porous silicon layer (103e) with a substantially uniform first porosity, and
   subjecting the silicon substrate to a second anodic process with a second anodization regime to obtain an internal portion of the porous silicon layer (103i) with a second porosity higher than the first porosity.

3. The method according to claim 1 or 2, further including the step of:

   covering each conductive element (115) with a layer of non-porous metal (115p).

4. The method according to any claim from 1 to 3, wherein the step of etching the porous silicon layer selectively includes:

   providing a plurality of etching masks (209a-209e) being stacked on the main surface, and
   repeating the steps of:

      etching a portion of the porous silicon layer (203) for a corresponding partial thickness lower than an initial thickness of the porous silicon layer through the masks, and
      removing an outermost mask in the stack,

   until the removal of all the masks.

5. The method according to any claim from 1 to 4, further including the steps of:

   embedding at least a prevalent portion of the conductive elements (315) into a dielectric layer (318) having a first main surface and a second main surface, the conductive elements crossing the dielectric layer from the first main surface to the second main surface, and
   removing the remaining portion of the silicon substrate (306).

**6.** A method for making a magneto-dielectric structure (315,318), the method including the step of:

> making the conductive microstructure by performing the steps of claim 5, the conductive elements (315) being of porous magnetic metal.

**7.** A method for making an interconnection structure (300), the method including the step of:

> making the conductive microstructure by performing the steps of claim 5.

**8.** A method for making an interconnection structure (300) according to claim 7, the method further including the steps of:

> forming a plurality of first contact elements (32 1 u) on the first main surface, the first contact elements being connected to selected conductive elements (315), and/or
> forming a plurality of second contact elements (321d) on the second main surface, the second contact elements being connected to the selected conductive elements.

**9.** A method for making a packaged electronic device (400;500;600), the method including the steps of:

> making the interconnection structure by performing the steps of claim 7 or 8,
> mounting at least one chip including an integrated circuit (424;524;624) on the first main surface, the chip having a plurality of internal terminals connected to a set of conductive elements (415;515;615), and
> forming a set of external terminals (430;530;630) on the second main surface, the set of external terminals being connected to the set of conductive elements.

**10.** A method for making a package-to-package electronic device (700), the method including the steps of:

> making a plurality of packaged electronic devices by performing the steps of claim 9,
> mounting the packaged electronic devices into a stack, wherein each packaged electronic device has a further set of conductive elements (715a-715d) being connected to the external terminals (730b-730d) of a following electronic packaged device in the stack, a first electronic packaged device in the stack including a further set of external terminals (730a) on the corresponding second main surface being connected to the corresponding further set of conductive elements (715a).

**11.** A method for making an electronic device (800), the method including the steps of:

> making the conductive microstructure by performing the steps of any claim from 1 to 4, and
> integrating at least one component (836) into the remaining portion of the silicon substrate (806), the conductive elements (815) defining a heat sink for the at least one component.

**12.** A method for making a vacuum electronic device (900), the method including the steps of:

> making the conductive microstructure by performing the steps of any claim from 1 to 4,
> forming a lateral protection element (915p) on the remaining portion of the silicon substrate (906), the lateral protection element surrounding the conductive elements (915o),
> bonding a first protection element (939) on a first free end of the lateral protection element and of each conductive element opposed to the remaining portion of the silicon substrate,
> removing the remaining portion of the silicon substrate, and
> bonding a second protection element (942) on a further free end of the lateral protection element and of each conductive element opposed to the first free end thereof under substantially vacuum conditions, the lateral protection element, the first protection element and the second protection element sealing the conductive elements.

**13.** A system (100-1000) being obtained by performing the steps of the method according to any claim from 1 to 12.

102

103e

103

103i

106

<u>FIG.1A</u>

109

103

106

<u>FIG.1B</u>

109

112

106

<u>FIG.1C</u>

100

115p

115

106

# FIG.1D

209e
209d
209c
209b
209a

203

206

## FIG.2A

209e
209d
209c
209b
209a

De

203

206

## FIG.2B

209d
209c
209b
209a

Dd

203

206

## FIG.2C

209c
209b
209a

Dc

203

206

**FIG.2D**

209b
209a

Db

203

206

**FIG.2E**

209a

Da

212

206

**FIG.2F**

200

215

206

## FIG.2G

FIG.3A

315
318
306

FIG.3B

315
318
306

FIG.3C

321u
315
318
306

//14

300

321u

315

318

321d

# FIG.3D

400 ⟍

433

422

427

421u

418

415

424

430

## FIG.4

500 ⟍

533

523

524

527

518

515

530

## FIG.5

**FIG.6**

## FIG.7

FIG.8

906

915o

915p

## FIG.9A

915o

939

915p

906

## FIG.9B

915o

939

915p

## FIG.9C

915o

939

915p

942

## FIG.9D

## FIG.10

**European Patent Office**

## EUROPEAN SEARCH REPORT

Application Number

EP 08 42 5186

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 0 499 488 A (CANON KK [JP]) 19 August 1992 (1992-08-19) * figures 5a-5d * | 1-3 | INV. H01L23/367 H01L23/498 H01L25/10 H01L21/68 |
| A | US 2006/234079 A1 (ZHANG XI [US] ET AL) 19 October 2006 (2006-10-19) * the whole document * | 1-3 | |
| A | EP 0 797 258 A (SONY CORP [JP]) 24 September 1997 (1997-09-24) * column 17, line 58 - column 18, line 1; figures 2A-2c * | 2 | |

TECHNICAL FIELDS
SEARCHED (IPC)

H01L

The present search report has been drawn up for all claims

| Place of search | Date of completion of the search | Examiner |
|---|---|---|
| The Hague | 3 October 2008 | Kästner, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 2 104 140 A1

## ANNEX TO THE EUROPEAN SEARCH REPORT
## ON EUROPEAN PATENT APPLICATION NO.

EP 08 42 5186

03-10-2008

| Patent document cited in search report | | Publication date | Patent family member(s) | | Publication date |
|---|---|---|---|---|---|
| EP 0499488 | A | 19-08-1992 | AT | 244931 T | 15-07-2003 |
| | | | CA | 2061264 A1 | 16-08-1992 |
| | | | SG | 47089 A1 | 20-03-1998 |
| | | | SG | 93197 A1 | 17-12-2002 |
| | | | US | 5767020 A | 16-06-1998 |
| US 2006234079 | A1 | 19-10-2006 | NONE | | |
| EP 0797258 | A | 24-09-1997 | JP | 2008177563 A | 31-07-2008 |

EPO FORM P0459

**EP 2 104 140 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Xi Zhang ; King-Ning Tu.** Preparation of hierarchically porous nickel from macroporous silicon. *J. Am. Chem. Soc.,* 2006, vol. 128, 15036-15037
- **M. Hayase et al.** Formation of porous ruthenium layer on porous silicon template. *Electrochem. Soc.,* 2006, vol. 153, C741
- Formation of composite nanostructures by corrosive deposition of copper into porous silicon. **H. Bandarenka ; M. Balucani ; R. Crescenzi ; A. Ferrari.** Superlattices and Microstructures. In Press, 24 January 2008

- **M. Hayase et al.** Miniature $250\mu$m thick full cell with monolithically fabricated silicon electrodes. *Electrochemical and Solid State Letters,* 2004, vol. 7 (8), A231-A234
- **F.A.Harraz et al.** Immersion plating of nickel onto a porous silicon layer from fluoride solutions. *Phys. Stat. Sol. (a),* 2003, vol. 197, 51-56
- **J. G. A. Brito-Neto et al.** Porous gold structures built on silicon substrates. *211th ECS Meeting Abstracts,* 2007
- Thermal conductivity and electrical resistivity of porous material. *CR-I20854,* October 1971